# EUROPÄISCHE PATENTANMELDUNG

(11) **EP 1 575 345 A2**
(43) Veröffentlichungstag der Anmeldung: **14.09.2005**
(21) Anmeldenummer: 05000959.6
(22) Anmeldetag: 19.01.2005
(51) Int. Cl.: H05K 5/02

(54) **Kunststoffgehäuse**

(30) Priorität: 20.01.2004 DE 102004003018; 26.02.2004 DE 102004009356
(71) Anmelder: Diehl AKO Stiftung & Co. KG, 88239 Wangen (DE)
(72) Erfinder: Brauchle, Andreas, 88410 Bad Wurzach (DE)
(74) Vertreter: Diehl Patentabteilung

(57) **Zusammenfassung**

Es wird ein Kunststoffgehäuse für eine elektrische oder elektronische Schaltung zur Unterbringung in einem elektrischen oder elektronischen Gerät vorgeschlagen, welches derart ausgeführt ist, dass die Schaltung im Gehäuse feuerfest gehalten ist. Das Gehäuse besteht aus mindestens zwei Gehäuseelementen (1,2), die miteinander lösbar verbunden sind und von denen das erste Gehäuseelement (1) aus feuerfestem Kunststoff und das zweite Gehäuseelement (2) aus nicht feuerfestem Kunststoff besteht. Das zweite Gehäuseelement (2) aus nicht feuerfestem Kunststoff kann mindestens eine Klappe aufweisen, die mittels eines Filmscharniers mit dem übrigen Teil des Gehäuseelementes (2) verbunden ist. Bei dem elektrischen oder elektronischen Gerät handelt es sich vorzugsweise um ein wasserführendes Haushaltsgerät, insbesondere eine Waschmaschine, einen Wäschetrockner oder einen Waschtrockner.

## Beschreibung

Die Erfindung betrifft ein Kunststoffgehäuse für eine elektrische oder elektronische Schaltung nach dem Oberbegriff des Patentanspruchs 1.

In wasserführenden Haushaltsgeräten wie z.B. Waschmaschinen müssen elektronische Schaltungen wie z.B. die Frequenzumrichter-Elektronik so in einem Gehäuse untergebracht sein, dass sie zum einen vor Spritzwasser geschützt sind und zum anderen bei einem Brand des Haushaltsgeräts in ihrer vorgesehenen Befestigungslage verbleiben und sich nicht lösen oder herunterfallen, da dabei das Gehäuse des Haushaltsgeräts unter elektrische Spannung gesetzt werden könnte.

Zu diesem Zweck wird die Frequenzumrichter-Elektronik einer Waschmaschine in einem Gehäuse untergebracht, welches vollständig aus einem Kunststoff mit Brandschutzausrüstung, d.h. aus einem feuerfesten Kunststoff besteht. Diese Lösung hat den Nachteil, dass solch ein feuerfester Kunststoff aufwändig und teuer in der Herstellung und eingeschränkt in der Verarbeitung ist.

Ausgehend von dem genannten Stand der Technik stellt sich nun der Erfindung die Aufgabe, ein gattungsgemäßes Kunststoffgehäuse vorzuschlagen, das einfacher und kostengünstiger herzustellen und flexibler zu bearbeiten ist.

Diese Aufgabe wird von einem Kunststoffgehäuse mit den Merkmalen des Patentanspruchs 1 erfüllt. Vorteilhafte Ausgestaltungen und Weiterbildungen der Erfindung sind in den abhängigen Ansprüchen beschrieben.

Der Kerngedanke der Erfindung liegt darin, dass nicht mehr das gesamte Gehäuse aus feuerfestem Kunststoff besteht, sondern nur noch derjenige Teil des Gehäuses, der die elektrische oder elektronische Schaltung hält. Dazu besteht das Gehäuse aus mindestens zwei Gehäuseelementen, die miteinander lösbar verbunden sind. Das erste Gehäuseelement ist aus feuerfestem Kunststoff gefertigt, während das zweite Gehäuseelement aus herkömmlichem, nicht feuerfestem Kunststoff besteht.

Durch die teilweise Verwendung von herkömmlichem Kunststoff wird die Herstellung des Gehäuses vereinfacht und verbilligt. Außerdem ergibt sich eine größere Variabilität und Flexibilität in der Gestaltung des Gehäuses.

Als Material für einen Kunststoff mit Brandschutzausrüstung eignet sich vorzugsweise PPE+S/B X oder PC-ABS-FR, als Material für einen herkömmlichen Kunststoff vorzugsweise PPTV20.

In Weiterbildung der Erfindung weist das zweite, aus nicht feuerfestem Kunststoff bestehende Gehäuseelement eine Klappe auf, die mittels eines Filmscharniers mit dem übrigen Teil dieses Gehäuseelementes verbunden ist. Solch ein Filmscharnier wäre bei einer ausschließlichen Verwendung von feuerfestem Kunststoff gar nicht oder nicht mit vertretbarem Aufwand bzw. vertretbaren Kosten realisierbar.

Diese Klappe kann eine oder mehrere Anschlussbuchsen oder -stecker der elektrischen bzw. elektronischen Schaltung schützen. Eine solche mittels Filmscharnier am zweiten Gehäuseelement angeformte Klappe kann alternativ auch derart mit dem ersten Gehäuseelement lösbar verbunden sein, dass das zweite Gehäuseelement über das Filmscharnier aufgeklappt und so das Gehäuse geöffnet (und auch wieder geschlossen) werden kann.

Die elektrische bzw. elektronische Schaltung ist innerhalb des Gehäuses vorzugsweise am ersten, aus feuerfestem Kunststoff bestehenden Gehäuseelement befestigt. Die Befestigung erfolgt in bevorzugter Ausführungsform mittels eines Befestigungselements aus feuerfestem Kunststoff. Als Befestigungselement findet in besonders bevorzugter Ausgestaltung ein Befestigungsrahmen aus PA66GF35FR Anwendung. Das Befestigungselement kann darüber hinaus auch eine Führung und eine Kodierung für die Anschlussbuchsen bzw. -stecker der elektrischen bzw. elektronischen Schaltung aufweisen. Dabei ist die Führung vorzugsweise so ausgeführt, dass sie gleichzeitig die Kodierung aufweist.

Das Gehäuse ist weiterhin so ausgeführt, dass die elektrische bzw. elektronische Schaltung darin vor Spritzwasser geschützt ist.

Die elektrische bzw. elektronische Schaltung wird vorzugsweise durch eine Leistungsschaltung gebildet, insbesondere durch eine Frequenzumrichter-Elektronik für einen Antriebsmotor einer Waschmaschine, eines Wäschetrockners oder eines Waschtrockners (Waschmaschine-Wäschetrockner-Kombination).

Anhand der Zeichnungen soll die Erfindung im Folgenden weiter erläutert werden. Es zeigen:

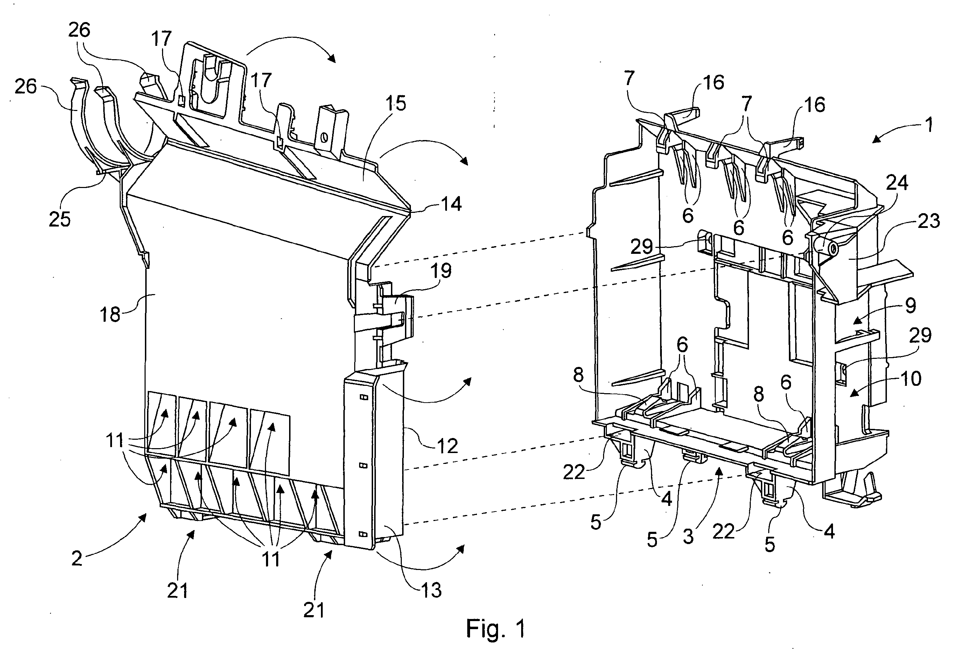

- Figur 1: ein Kunststoffgehäuse für eine Frequenzumrichter-Elektronik für eine Waschmaschine in Explosionsdarstellung perspektivisch von seitlich vorne und

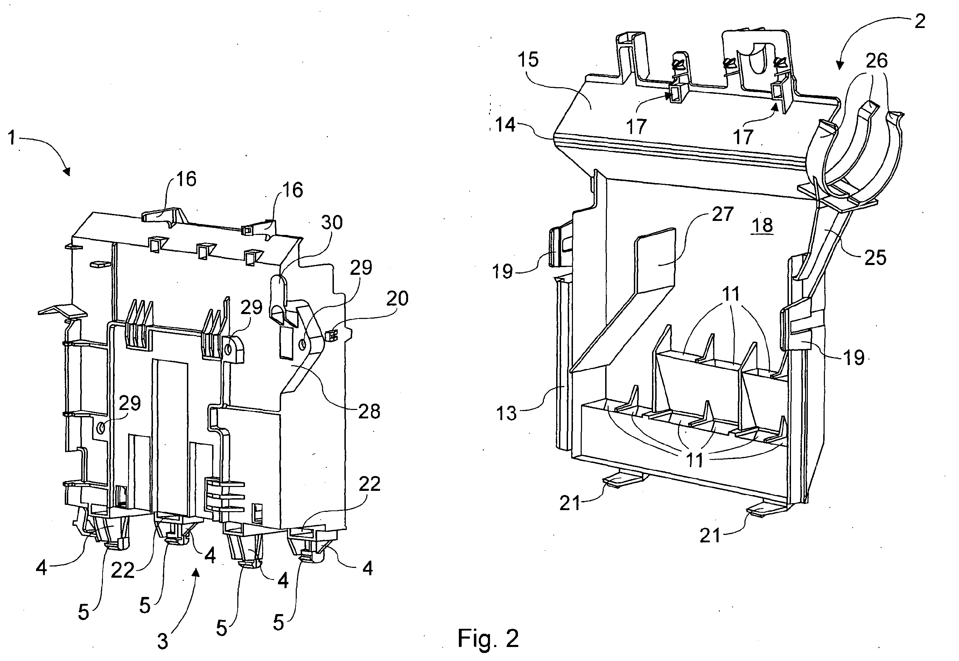

- Figur 2: das Kunststoffgehäuse von Figur 1 in Explosionsdarstellung von seitlich hinten.

Ein Kunststoffgehäuse für eine Waschmaschinen-Frequenzumrichter-Elektronik besteht aus zwei Gehäuseelementen, wobei das erste Gehäuseelement in Form eines Rückseitenteils 1 aus dem Kunststoff PPE+S/B X (mit Brandschutzausrüstung) besteht, während das zweite Gehäuseelement in Form des Vorderteils 2 aus dem nicht feuerfesten Kunststoff PPTV20 gefertigt ist.

An der Unterseite 3 des Rückseitenteils 1 sind vier Standfüße 4 angeformt, an deren Unterseite wiederum Befestigungselemente 5 mit einem Querschnitt in Form eines umgedrehten T angeformt sind. Mit diesen Befestigungselementen 5 können die Standfüße 4 durch entsprechende Schlitze in einer Stand- bzw. Bodenplatte der Waschmaschine hindurchgreifen bzw. diese Stand- bzw. Bodenplatte hintergreifen, wodurch für eine sichere Befestigung des Kunststoffgehäuses in der Waschmaschine gesorgt ist.

Auf der Innenseite des Rückseitenteils 1 sind diverse Anschläge 6 ausgeformt, an welche eine die Frequenzumrichter-Elektronik für die Waschmaschine tragende Leiterplatte (nicht gezeichnet) angelegt werden kann. Auf die Vorderseite dieser Leiterplatte wird sodann ein Befestigungsrahmen aus dem ebenfalls feuerfesten Kunststoff PA66GF35FR aufgelegt (ebenfalls in den Figuren nicht gezeigt). Der Befestigungsrahmen wird durch Hinterschneidungen der an dem Rückseitenteil 1 angeformten Befestigungshaken 7 und durch diesen gegenüberliegende und ebenfalls am Rückseitenteil ausgeformte Schnapphaken 8 festgehalten, so dass sich auf diese Weise eine stabile Halterung der die Frequenzumrichter-Elektronik tragenden Leiterplatte ergibt.

Die Leiterplatte mit der Frequenzumrichter-Elektronik kann auch vor dem Einlegen in das Rückseitenteil an dem Befestigungsrahmen mittels Schnapphaken, Schrauben o.ä. befestigt und dann zusammen mit dem Befestigungsrahmen in das Rückseitenteil eingelegt werden. Dabei kann der Befestigungsrahmen auch so ausgeführt sein, dass er selbst (und nicht die Leiterplatte) an den Anschlägen 6 aufliegt.

Das Rückseitenteil 1 weist weiterhin Öffnungen 9 und 10 auf, durch welche auf der Leiterplatte befindliche Anschlussbuchsen zugänglich sind. Die Anschlussbuchsen können direkt auf der Leiterplatte montiert sein. Sie können aber auch durch Führungselemente, die an dem Befestigungsrahmen ausgeformt sind und auch gleichzeitig eine Steckerkodierung aufweisen, zusammen mit auf der Leiterplatte befindlichen Kontaktstreifen gebildet sein.

Das Vorderteil 2 des Gehäuses weist mehrere Lüftungsschlitze 11 auf, durch welche Kühlluft in das Innere des Gehäuses eintreten kann. Auf einer Seite des Vorderteils 2 ist mittels eines Filmscharniers 12 eine Schutzklappe 13 angeformt, welche im zusammengebauten Zustand des Gehäuses vor die Öffnungen 9 und 10 einrastbar geklappt werden kann, um ein Eindringen von Spritzwasser durch diese Öffnungen 9 und 10 in das Innere des Gehäuses und vor allem auf die Frequenzumrichter-Elektronik zu verhindern. Dabei ist gewährleistet, dass auch bei geschlossener Schutzklappe 13 ein Schlitz zum Durchtritt von mit den auf der Leiterplatte befindlichen Anschlussbuchsen verbundenen Kabeln offen bleibt.

Am oberen Ende des Vorderteils 2 ist ebenfalls über ein Filmscharnier 14 eine Befestigungsklappe 15 angeformt. Diese kann im zusammengebauten Zustand des Gehäuses um die Oberseite des Rückseitenteils 1 herumgeklappt werden, wobei an der Oberseite des Rückseitenteils 1 angeformte Schnapphaken 16 durch Aussparungen 17 in der Befestigungsplatte 15 des Vorderteils 2 hindurchgreifen und einschnappen. Dadurch und durch (nicht gezeigte) Abstützelemente ist das Vorderteil 2 über seine Befestigungsklappe 5 am Rückseitenteil 1 befestigt. Um das Filmscharnier 14 zwischen dem Befestigungsteil 15 und dem Hauptkörper 18 des Vorderteils 2 herum kann dieser Hauptkörper 18 nun herumgeklappt werden, so dass das Gehäuse durch Auf- und Zuklappen des Hauptkörpers 18 des Vorderteils 2 geöffnet und geschlossen werden kann.

Beim Schließen des Gehäuses durch Zuklappen des Hauptkörpers 18 des Vorderteils 2 schnappen zum einen Haltelaschen 19, die seitlich am Vorderteil 2 angeformt sind, hinter entsprechenden Befestigungshaken 20 ein, welche an den Seiten des Rückseitenteils angeformt sind. Zum anderen greifen an der Unterseite des Vorderteils angeformte Schnapphaken 21 durch im oberen Bereich der vorderen Standfüße 4 des Rückseitenteils ausgeformte Öffnungen 22 hindurch, um mit ihren Hinterschneidungen hinter dem Austritt der Öffnungen 22 zu verhaken.

Zur Befestigung des gesamten Gehäuses am Haushaltsgerät dient neben den Standfüßen 4 noch ein seitlich am Rückseitenteil 1 angeformter Schraubdom 23 mit einer Schraubenführungshülse 24.

Auf der gegenüberliegenden Seite ist am Vorderteil ein Haltearm 25 mit Rohrhaltekrampen 26 angeformt, welcher als Schlauchhalter dient.

Auch bei geschlossenem Gehäuse bleiben im oberen Bereich des Gehäuses an den Seiten Öffnungen frei, die einen Durchtritt von Kühlluft ermöglichen. Somit kann unterhalb des Filmscharniers 14 zwischen dem Hauptkörper 18 und der Befestigungsklappe 15 des Vorderteils 2 Kühlluft, welche durch die Lüftungsöffnungen 11 im Vorderteil 2 ins Gehäuse eingedrungen ist und über die Frequenzumrichter-Elektronik bzw. über mit auf dieser befindlichen Leistungsteilen thermisch gekoppelte Kühlkörper geführt und erwärmt wurde, auf beiden Seiten des Gehäuses wieder austreten. Durch eine schräge Ausführung des oberen Abschlusses des Vorderteils 2 wird dabei zusätzlich noch eine Sogwirkung erzielt, wobei Kühlluft an der niedriger ausgeführten Seite des Gehäuses ein- und an der höher ausgeführten Seite des Gehäuses (am Schlauchhaltearm 25) wieder austritt und dabei verstärkt Kühlluft durch die unteren Kühlöffnungen 11 ansaugt. Verstärkt wird dieser Effekt noch durch eine an der Innenseite des Vorderteils ausgeführte Luftleitwand 27.

Im Rückseitenteil 1 bzw. in einem an diesem angeformten Befestigungsfortsatz 28 sind Löcher 29 angeordnet, in welche Kabelhaltebänder bzw. Bandhalter für Kabelhaltebänder oder auch -Schellen eingeschnappt werden können. Zusammen mit einer Kabelführung 30, die ebenfalls am Befestigungsfortsatz 28 angeformt ist, können so Kabel bzw. Kabelbäume, die innerhalb des elektrischen bzw. elektronischen Geräts angeordnet sind, am Gehäuse fest fixiert werden, wodurch ein Durchscheuern der Kabel verhindert werden kann.

## Patentansprüche

1. Kunststoffgehäuse für eine elektrische oder elektronische Schaltung zur Unterbringung in einem elektrischen oder elektronischen Gerät, vorzugsweise einem wasserführenden Haushaltsgerät, insbesondere Waschmaschine, Wäschetrockner oder Waschtrockner, wobei das Gehäuse derart ausgeführt ist, dass die Schaltung im Gehäuse feuerfest gehalten ist,
**dadurch gekennzeichnet,**
**dass** das Gehäuse aus mindestens zwei Gehäuseelementen (1, 2) besteht, die miteinander lösbar verbunden sind, von denen das erste Gehäuseelement (1) aus feuerfestem Kunststoff und das zweite Gehäuseelement (2) aus nicht feuerfestem Kunststoff besteht.

2. Kunststoffgehäuse nach Anspruch 1,
**dadurch gekennzeichnet,**
**dass** der feuerfeste Kunststoff ein Kunststoff mit Brandschutzausrüstung, vorzugsweise PPE+S/B X oder PC-ABS-FR, und der nicht feuerfeste Kunststoff ein Kunststoff ohne Brandschutzausrüstung, vorzugsweise PPTV20, ist.

3. Kunststoffgehäuse nach Anspruch 1 oder 2,
**dadurch gekennzeichnet,**
**dass** das zweite Gehäuseelement (2) mindestens eine Klappe (13, 15) aufweist, die mittels eines Filmscharniers (12, 14) mit dem übrigen Teil (18) dieses Gehäuseelementes (2) verbunden ist.

4. Kunststoffgehäuse nach Anspruch 3,
**dadurch gekennzeichnet,**
**dass** eine erste Klappe (13) eine oder mehrere Anschlussbuchsen oder - stecker der elektrischen oder elektronischen Schaltung schützt.

5. Kunststoffgehäuse nach Anspruch 3,
**dadurch gekennzeichnet,**
**dass** eine zweite Klappe (15) mit dem ersten Gehäuseelement (1) lösbar verbunden ist und das Gehäuse durch Aufklappen des zweiten Gehäuseelements (2) über das Filmscharnier (14) der zweiten Klappe (15) geöffnet werden kann.

6. Kunststoffgehäuse nach einem der vorherigen Ansprüche,
**dadurch gekennzeichnet,**
**dass** die elektrische oder elektronische Schaltung innerhalb des Gehäuses am ersten Gehäuseelement (1) befestigt ist.

7. Kunststoffgehäuse nach Anspruch 6,
**dadurch gekennzeichnet,**
**dass** die Befestigung der elektrischen oder elektronischen Schaltung am ersten Gehäuseelement (1) mittels eines Befestigungselements, vorzugsweise eines Befestigungsrahmens, aus feuerfestem Kunststoff, vorzugsweise aus einem Kunststoff mit Brandschutzausrüstung, insbesondere aus PA66GF35FR, erfolgt.

8. Kunststoffgehäuse nach Anspruch 7,
**dadurch gekennzeichnet,**
**dass** des Befestigungselement eine Führung und eine vorzugsweise in der Führung befindliche Kodierung für die Anschlussbuchsen oder -stecker der elektrischen oder elektronischen Schaltung aufweist.

9. Kunststoffgehäuse nach einem der vorherigen Ansprüche,
**dadurch gekennzeichnet,**
**dass** die elektrische oder elektronische Schaltung innerhalb des Gehäuses vor Spritzwasser geschützt ist.

10. Kunststoffgehäuse nach einem der vorherigen Ansprüche,
**dadurch gekennzeichnet,**
**dass** die elektrische oder elektronische Schaltung eine Leistungsschaltung ist, vorzugsweise eine Frequenzumrichterschaltung für einen Antriebsmotor einer Waschmaschine, eines Wäschetrockners oder eines Waschtrockners.
